# EUROPEAN PATENT APPLICATION

(11) **EP 1 667 246 A1**
(43) Date of publication of application: **07.06.2006**
(21) Application number: 04028707.0
(22) Date of filing: 03.12.2004
(51) Int. Cl.: H01L 51/42, H01L 27/146

(54) **A multi-colour sensitive device for colour image sensing**

(71) Applicant: ETeCH AG, 8952 Schlieren (CH); EPFL Service des Relations Industrielles (SRI), 1015 Lausanne (CH)
(72) Inventor: Graetzel, Michael, 1025 St-Sulpice (CH); Edge, Gordon, Great Chesterford Essex CB10 1NP (GB); Artley, Richard John, 8001 Zürich (CH); Bach, Udo, 78247 Hilzingen (DE)
(74) Representative: Liebetanz, Michael

(57) **Abstract**

A sensor element (1, 20, 21, 22) capable of sensing more than one spectral band of electromagnetic radiation with the same (x-y) spatial location, especially where the dimensions x-y-z form a set of Cartesian coordinates with z parallel to the direction of incident electromagnetic radiation, is characterized in that the element consists of a stack of sub-elements (3, 5, 7) each capable of sensing different spectral bands of electromagnetic radiation. These sub-elements (3, 5, 7) each contain a non-silicon semiconductor where the non-silicon semiconductor in each sub-element (3, 5, 7) is sensitive to and/or has been sensitized to be sensitive to different spectral bands of electromagnetic radiation.

## Description

### Background of the Invention

State-of-the-art colour image detectors used for imaging purposes, such as the charge-coupled devices used in still- and video-camera imaging systems, are almost exclusively based on inorganic semiconductor electronics such as silicon, to which colour filters are applied.

It should be noted that although 'colour detection' is normally synonymous with 'visible electromagnetic radiation detection', this method can also be used to gain information on the spectral distribution of electromagnetic radiation outside the range of visible light (e.g. ultraviolet, infrared or x-ray), using filter layers with the according transmission properties.

This arrangement allows the intrinsic photo response characteristics of the semiconductor material to be limited and controlled in order to create sensor elements with specific spectral response characteristics. The semiconductor can be patterned to provide many individual photo sensors on a single substrate, and the colour filter can be likewise pattered to the same (x-y) dimensions. If it is desired to sense more than one colour with the same photo sensor substrate, particularly to capture a colour image, conventionally the colour filter is patterned with a pixel (picture-point) array of different colour filters, which conventionally control the light transmitted through the filter to adjacent photo sensors. Using pixel elements with different color filters next to each other in a two-dimensional array makes it possible to provide color information for the image detected. Sensing devices applying color filters generally consist of sensor elements lying side-by-side on a sensor plain. Using the response of neighboring pixel elements with different sensitivities (typically three to four) it is possible to measure light intensity as well as the spectral distribution of light at a given point.

Thus, since capturing a colour image needs capturing at least the red, green and blue elements of the image, the size of one pixel for which full colour information is known is (by area) at least three times greater than the size of the corresponding photo sensor elements: or, to express this in a different way, the areal colour resolution of the colour image detector is at best a third of that which would be achievable for a black-and-white image using the same photosensitive detector array.

In this respect we define in this application a pixel of picture-point an area for which full colour information is directly measured or transmitted and therefore the number of pixels in an array or display is the number for which distinct full colour information is measured (and not interpreted) or transmitted.

Although this does not take into consideration the complex information sharing between sub-pixels, it can be stated that according to the prior art one pixel is an array of 3 to 4 monochrome sub-pixels as mentioned above.

Besides the lesser resolution, there are other drawbacks to the creation of colour images by division of detector area in this way. In particular, the creation of the colour filter is far from easy. The colour filter has to be deposited with precise evenness at a resolution of typically 1-100 micrometers - which is progressively more difficult to do as the pixel size decreases. Also, the regular arrays of colour pixels lead to imaging artifacts termed Moiré patterns.

It is of course possible in theory to simply scale up the size of the detector for any given picture resolution, using tiling methods for the detectors if the whole exceeds critical dimensions, and then use appropriate imaging optics, but for most practical applications this is both cumbersome and expensive. Production costs of sensor arrays scale usually almost linearly with sensor size.

Furthermore, it is known from US 6'727'521 to bypass the problems of the (x-y) areal arrays of different coloured pixels by instead stacking the sensors vertically, i.e. in the z-direction, parallel to the light coming from the scene being imaged.

Such a geometry has also been disclosed in US 6'632'701 ('Vertical color filter detector group and array'), and is manufactured by Foveon Inc (Santa Clara, USA) under the trademark X3 Image Sensors. In said device a geometry is disclosed with stacked doped n- and p-layers embedded in silicon semiconductors, relying for its effect on the observation that red, green and blue light penetrate such silicon semiconductors to different depths. Someone skilled in the art will admit that it will be nearly impossible to achieve infrared or ultra-violet detection with a scheme according to US 6,632,701.

### Summary of the Invention

Therefore it is an object of the present invention to improve the semiconductor image detector according to the preamble of claim 1 in view of production costs, image quality and/or colour separation and image signal treatment.

Said object has been achieved with a semiconductor image detector with the characteristic features according to claim 1.

A new type of colour image sensor is described where different colours are sensed with the same (x-y) spatial coordinates. This is achieved by using a stack of sensors each of which is sensitive to one colour and transparent to others. This thus allows the creation of a device, composed of such sensing elements, to have high spatial resolution, and avoid certain sensing artifacts, compared with most other known state of the art devices. The use of dye-sensitized wide-bandgap semiconductors allows a higher degree of control over the colour sensitivity of the devices than that obtained with other known vertical-stack devices based on doped conventional semiconductors, in particular allowing sensitivity to narrow bands of electromagnetic radiation, and to electromagnetic radiation beyond the human-visible range.

The present invention allows the colour pixel to be the same size as the sensor pixel, resulting in at least a three-fold improvement in areal resolution for a device of equivalent photo sensor size (or a corresponding decrease in sensor array size for equivalent picture resolution, provided the photo sensor elements may be reduced so far in size; or any suitable compromise between the two, following the definition above). It also, importantly, by removing the conventional patterned colour filters, removes many of the problems with manufacture of colour filters (e.g., achieving evenness, dimensional match to the sensor array, problems with patterning defect-free at this high resolution). It also removes almost all the problems with Moiré patterns.

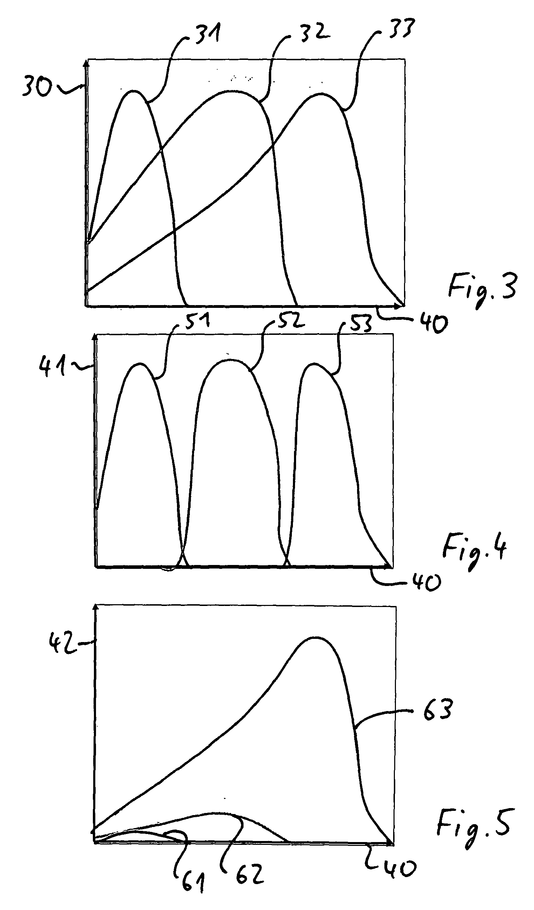

According to the present invention, such a device to realize sensor arrays that are stacked perpendicular to the imaging plane may also for instance be made practically by using dye-sensitized wide bandgap semiconductor layers. In this case semiconductor layers sensitized with different dyes are employed, each of which will select light of one different non-significantly overlapping specific narrow range of wavelengths, and remain transparent to all others. The dyes are typically used in combination with a semiconductor, which will only react photosensitively to light when the semiconductor has been sensitized by the dyes. It is also possible to have a distribution of the dye absorption in the different layers according to Fig. 3 and achieve separated and therefore non-significantly overlapping wavelengths responses.

Such dyes, and such semiconductors, are known from the field of dye-sensitized solar cells. Dye-sensitized solar cells make use of synthetic or naturally occurring dyes to sensitize wide-bandgap semiconductors such as titanium dioxide to visible light. The wide-bandgap semiconductor itself generally exhibits a strong roughness resulting in a high specific surface area. The dyes themselves provide the spectral sensitivities - no additional colour filters are required to create sensors with different spectral sensitivities. Thus the different spectral sensitivities of individual sensor layers are achieved by the use of different, (in the final result) non-significantly interfering, spectral sensitizers.

The use of such materials in solar cells is well known, and their use in simple light intensity detectors has also been described before in literature. See for example WO 99/45595 photodetector and use of the same, DE 43 06 407 Detector, JP 2002/310793 High-sensitivity light receiving element and image sensor, JP 2002/359364 Optical sensor and optical sensor unit. All of these however describe single-element sensors, or in the case of JP 2002/359364, a one-dimensional (1D) linear sensor, and all are monochromatic or undifferentiating between incident wavelengths.

The use of such systems with a single-layer 2D array to detect 'black and white' images, again monochromatic (within a single particular wavelength band within the visible spectrum), or undifferentiating between incident wavelengths, is described in Preferred Embodiment Eight ('Two-Dimensional Image Sensor') of US 2001/0028026 'Photodetector and photo detecting system'.

However the concept of stacking different arrays of dye-sensitized wide-bandgap semiconductors with different, mutually non-competing spectral responses, to achieve colour image capture, has not been previously disclosed.

One particular advantage of the present invention is the flexibility it permits in design and manufacture. In the device according to US 6'632'701, the order of the layers is necessarily fixed in descending wavelength chromatic sequence because it relies on wavelength-related penetration depth; the choice of wavelength of any one layer restricts the wavelength choice of other layers, closely separated wavelengths being impossible to measure because the physical size of the associated structures then prevent certain penetration depths being accessed; wavelengths beyond the human-visible range are not included (possibly an ultra-violet upper layer would be too shallow to construct, and a infra-red layer too deep for a strong enough signal to be sensed, in a single device with fixed dynamic ranges); and the image has to be deconvoluted from the measured signals because the upper layers of the device also measure electromagnetic radiation at wavelengths intended to be measured at the lower levels of the device (i.e., the uppermost 'blue' sensing layer will also absorb and record green and red light).

In contrast, the present device has none of the above restrictions. The order of the layers is not necessarily fixed in descending chromatic sequence, although this may of course be desirable, because the sensing technology used is not penetration-depth dependant: thus, for instance, a five-layer device measuring infra-red, red, green, blue and ultra-violet signals could be constructed with 120 different possible layer sequences, the optimal one being chosen dependant on the desired results and the sensitivities of the possible layers; and here again, it has to be noted that different dyes could be used to enable different sensitivities to the same narrow wavelength band. Closely spaced wavelength can, if desired, be accurately sensed because the layers do not physically restrict this. Wavelengths beyond the human-visible range are readily detectable with appropriate dyes. Lastly, deconvolution is easier, because although there will be some absorption by the upper layers of wavelengths intended to be measured by the lower layers, this can be avoided to a much greater extent. It also provides that more of the incoming radiation is correctly sensed in the appropriate layers, thus providing a device of greater and more accurate sensitivity as well as improved resolution, which in turn makes reconstruction of a full true-colour image, or whatever false-colour images may be desired, much easier.

A single sensor element itself is subject matter of claim 1. A device containing multiples sensor elements is claimed in claim 14.

According to one embodiment of the invention the sensitization is achieved through the use of dyes within the wide-bandgap semiconductors.

According to one embodiment of the invention the sensor element is positioned in an array, which is not necessarily a regular array, e.g. a number of sensors can be arranged in different distances one from another.

According to another embodiment of the invention the sensor elements can be used for image capture or for non-image capture applications.

According to one embodiment one spectral band is in the human-visible range and in other embodiments a band is in the non-human visible range.

A preferred embodiment uses the full-colour human visible range.

Another embodiment uses regular 2D arrays, i.e. direct image capture. Such arrays are not necessarily planar.

Another embodiment uses regular 1D arrays and scanning techniques, i.e. 'indirect' capture. Such arrays are not necessarily linear.

According to another embodiment a 0D array and scanning techniques are used, i.e. very indirect capture, e.g. a single element of one type, scanning, as part of an array of array of such. There can be provided a first sensor (high IR, low IR) next to a second sensor (R,G,B) and next to a third sensor (low UV, high UV), all scanning, wherein the match-up being done in the computing.

According to an embodiment the stack of sub-elements is parallel, wherein in other embodiments the stack is non-parallel to the front surface, i.e. inclined, circular, spherical, including domed or cylindrical, or parabolic geometries etc..

### Short description of the drawings

The invention will now be described by the following description of embodiments according to the invention, with reference to the drawing, in which:
- Fig. 1: shows a schematic cross-sectional view of a sensor according to the invention showing the geometry of the layers and contacts;
- Fig. 2: shows a schematic cross-sectional view of a device according to the invention with 3 sensors according to Fig. 1;
- Fig. 3: shows a graphic illustration of the absorption for three dyes in dependency on their wavelength;
- Fig. 4: the signal response for a sensor according one embodiment of the invention following Fig. 1 or Fig. 2;
- Fig. 5: the signal response for a stacked sensor according to prior art or stacked in a non preferred way;
- Fig. 6: the absorption spectra of mesoporous titanium dioxide films dyed with merocyanine dyes Sc1, Sc2 and Sc3;
- Fig. 7: the normalized spectral response (IPCE) of individual photoelectrochemical cells assembled from the dyesensitized TiO₂ films shown in Fig. 6;
- Fig. 8: the spectral response of the cells of Fig. 6 and 7; and
- Fig. 9: said cells integrated into a stack.

### Detailed description of preferred embodiments

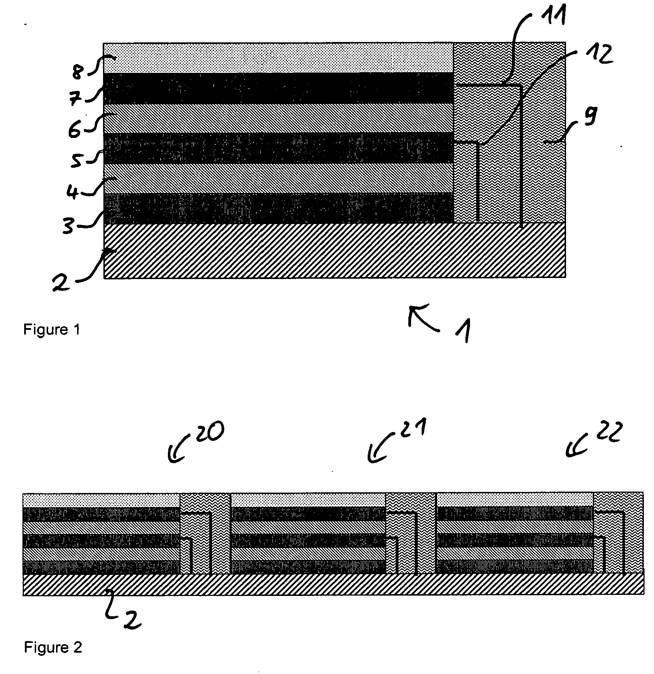

A colour sensing image device comprises a plurality of sensors 1. One such sensor is shown in Fig. 1 with a schematic cross-sectional view showing the geometry of the layers and contacts. Each sensor 1 represents one pixel.

The colour sensing image device consists preferably of a two-dimensional array of pixels, each one of which is preferably identical, and consists of a number of similar but non-identical layers, as shown in Figure 1 (layers 3, 4, 5, 6, 7, and 8), on top of a substrate 2. Said substrate 2 also supports various elements 9 interspersed among the pixels 1. The substrate 2 and the elements 9 are structures into which electronic connections 11 and/or active electronic components are embedded to permit addressing of upper layers 3 to 8. Preferably these contain electronic components of a charge coupled device as known to someone skilled in the art. For sake of simplicity these connections and components are not explained further.

Two or more photosensitive or photoactive layers (layer 3, 5, 7) are deposited onto the substrate 2, separated by insulating layers 4 and 6 deposited alternately with the photosensitive or photoactive layers. These photosensitive or photoactive layers 3, 5, and 7 contain a conducting or semiconducting material in which charge is generated upon excitation with electromagnetic radiation. Radiation is either absorbed by the semiconducting or conducting material itself, or preferably by a sensitizer, which sensitizes the generation of charge in the semiconducting or conducting material. Due to the use of different sensitizers or different semiconducting or conducting materials the different layers exhibit different spectral sensitivities towards electromagnetic radiation. In this context the wording "sensitivity to narrow bands of electromagnetic radiation" means that said material is only able to absorb light from a part of an existing spectrum. It has to be noted that the concept of narrow sensitivity of a lower layer 3 may also comprise and extend to wavelength portions which are already covered by another upper layer, e.g. 5 or 7, because light from said portions of a spectrum will already be absorbed before entering said lower layer, e.g. 3 or 5.

Preferably the photosensitive or photoactive layers 3, 5, and 7 each consists of a porous inorganic semiconductor with an average pore size from 2 - 500 nm. The layer may also contain a second medium capable of transporting charge. The conductor/semiconductor and the medium preferably form an interpenetrating network. Preferably this medium is a semiconductor, an organic charge transport material or a solid or liquid electrolyte.

The photoactive layers are separated by insulating layers (layer 4 and 6). These insulators are preferably porous with an average pore size from 2 - 1000 nm and may contain the same medium as described for layers 3, 5 and 7.

Element 9 is an insulator positioned on one side of or surrounding the layers 3 to 7 or as shown 8. Element 9 hosts electric connections 11, 12 between the photoactive layers and the substrate 2. Each photosensitive layer 3, 5, 7 can thereby be addressed via the electronic components or conducting leads 11, 12 of the substrate 2. Electrical contact to the medium is thus either provided via direct contact of the medium and an electric connection in the substrate 2 or via element 9: and/or a further layer 8 or layers can be deposited on top of the uppermost sensitive layer which provides electrical contact to the medium, provided that this layer or layers is/are so constituted and/or designed that it does/they do not block access of electromagnetic radiation to the photosensitive layers.

All layers can hold additional materials, which absorb electromagnetic radiation. Preferably these materials are optical filter substances.

As noted above assembling several pixels 1 as described in Figure 1 in parallel will produce a one or two dimensional array (see Figure 2 with three pixel 20, 21 and 22) - preferably these pixels form a 2-dimensional array which is then useable for imaging purposes. They can be formed on a common substrate 2.

The present invention can be used for example in a two-dimensional embodiment to directly capture images, as in a charge-coupled device, or in a one-dimensional, preferably linear array, to scan images, as in a colour copier.

In another embodiment the detector 1 comprises a stack of sub-elements stacked parallel or inclined to the direction of the incoming electromagnetic radiation, which is oriented, in Fig, 1 or 2 as to be oriented vertically to the front surface 8 of the pixel detectors 1, 20, 21 or 22.

The stack elements can be produced as layers 3, 4, 5, 6, 7 and 8 perpendicular to the main direction of the incident light. However it is also possible to prepare the layers with a lateral step-function, i.e. when the angle of incidence is not perpendicular to the surface of layer 8 but oblique and inclined. The layers 4 and 6 are insulating and/or carry the preferably transparent electrodes to be connected with the control unit of the pixel and the device as a whole.

Fig. 3, 4 and 5 show two embodiments of a distribution of the dyes used for absorption in the different layers according to Fig. 3 and the resulting wavelengths responses. Fig. 3 shows a graphic illustration of the absorption 30 for three dyes in dependency on their wavelength 40; Fig. 4 shows the signal 41 of the signal responses for a sensor according one embodiment of the invention following Fig. 1 or Fig. 2 against the wavelength 40; and Fig. 5 shows the signal 42 of the signal response for a stacked sensor according to prior art or stacked in a non preferred way.

The reference numerals 31, 32 and 33 designate the absorption curves of three different dyes; from left to right a blue dye, a green dye and a red dye. The name of the dyes relates to the main colour component they absorb. It can be seen that the absorption curves 31, 32 and 33 are overlapping.

In an embodiment of a device according to Fig. 1 and 2 the sequence of the different photosensitive layers 3, 5 and 7 comprises the red, the green and the blue dye, respectively. Said dyes having the absorption curves 31, 32 and 33, respectively, have the following effect on the transmitted light. The uppermost, the blue dye layer 7 with absorption curve 31 absorbs light from said wavelength range, giving as a result the signal response 51 as shown in Fig. 4. The not absorbed light, i.e. having a greater wavelength (greener and red), travels through layer 6 and enters layer 5. The so called green dye layer 5 with absorption curve 32 absorbs light from said wavelength range, giving as a result the signal response 52 as shown in Fig. 4. The not absorbed light, i.e. having a even greater wavelength (here: red and infrared), travels through layer 4 and enters layer 3. The so called red dye layer 3 with absorption curve 33 absorbs light from said wavelength range, giving as a result the signal response 53 as shown in Fig. 4. It can be seen by comparison of the three signal responses 51, 52 and 53 that non-significantly overlapping is achieved and the three colour signals are mainly separated. This result is not achievable with a device according US 6'632'701.

Fig. 5 now shows another embodiment wherein the colours used within the stacked layers 3, 5 and 7 are inverted, i.e. the uppermost layer is the red layer with the absorption curve 33, followed by the green layer with the absorption curve 32 and finally the bottom layer is the blue layer with the absorption curve 31. Then the signal answers of the different layers are 63, 62 and 61, respectively.

The choice of and the sequencing of appropriate photosensitive or photo-active materials known by someone skilled in the art or dyes permits a very high wavelength sensitivity simultaneously with very high resolution for all the narrow wavelength bands selected across the wavelength range selected. It is also possible to use quantum-dots. Quantum dots are small devices that contain a tiny droplet of free electrons. They are fabricated in semiconductor materials and have typical dimensions between nanometers to a few microns. Such sensitization can be reached - but is not limited to - by a thin layer of a narrow bandgap semiconductor or particles of the said narrow bandgap semiconductor deposited on top of the wide bandgap semiconductor with a layer thickness or average particle diameter respectively of typically 1 to 400 nm.

An embodiment of dye-sensitized cells based on different merocyanine sensitizers were assembled. The individual spectral photocurrent responses of individual cells as well as cells within a stack of cells were measured. The results show the feasibility to sense the colour distribution of light with dye-sensitized photovoltaic devices without any need for additional colour filters.

Thin (3 to 4.5 micrometer) mesoporous films of titanium dioxide were deposited onto conducting glass substrates according to M.K. Nazeeruddin et al., J. Am. Chem. Soc. 115 (1993) 6382. The average TiO₂ particle size was 18 nm. The so-prepared films were sintered at 450°C for 20 minutes. The geometrical surface area of each pixel was 0.28 cm². For some samples a dense TiO₂ layer (see below for an explanation about the advantages of use of such an additional layer) was deposited onto the conducting glass substrate prior to the deposition of the nanostructured TiO₂ electrode via a spray pyrolysis process described in L. Kavan, M. Graetzel, Electrochimica Acta 40 (1995) 643. The thickness of the dense tin layer can be chosen as described in the reference.

The so-prepared films were immersed into an alcoholic solution (0.5 mg/ml) of different merocyanine dyes as mentioned below for 48 hours at room temperature. The dyed TiO₂ electrodes were rinsed with ethanol and dried in air. A transparent counter electrode was prepared, consisting of conducting glass and a thin layer of platinum according to N. Papageorgiou, W. F. Maier, M. Graetzel, J. Electrochem Soc. 144 (1997) 876. Closed photoelectrochemical cells were assembled according to P. Wang et al., Nature Materials 2 (2003) 402. The electrolyte used contained an organic solvent, 0.5 moles/liter lithium iodide and 0.02 moles/liter iodine. The spectral response (IPCE) was measured with a computerized calibrated set-up comprising a xenon lamp, a monochromator, a Keithley sourcemeter and a calibrated silicon photodiode. The incident photon to electron conversion efficiency (IPCE) corresponds to the ratio of incident photons to collected electrons in the external circuit of the photovoltaic device under short-circuit conditions under monochromatic illumination.

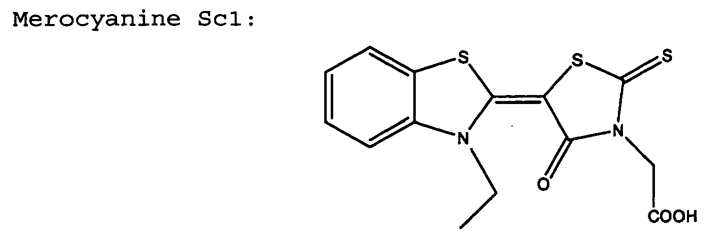

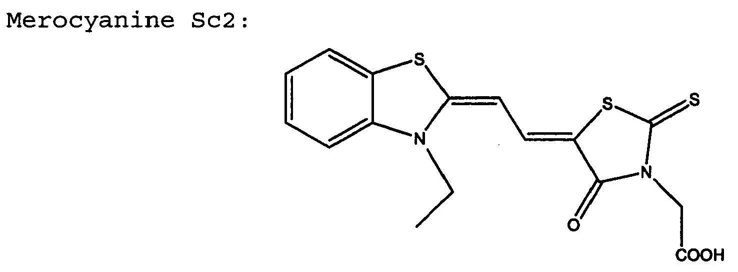

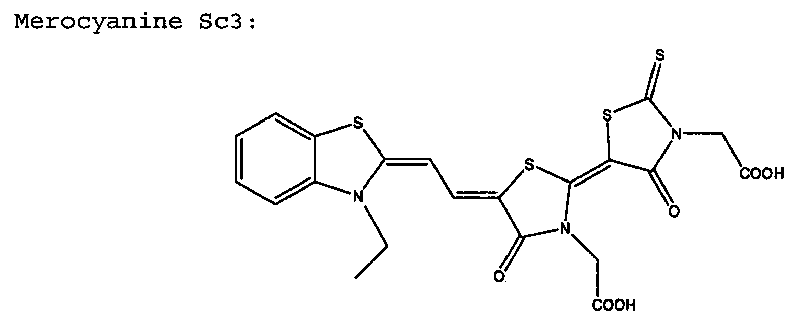

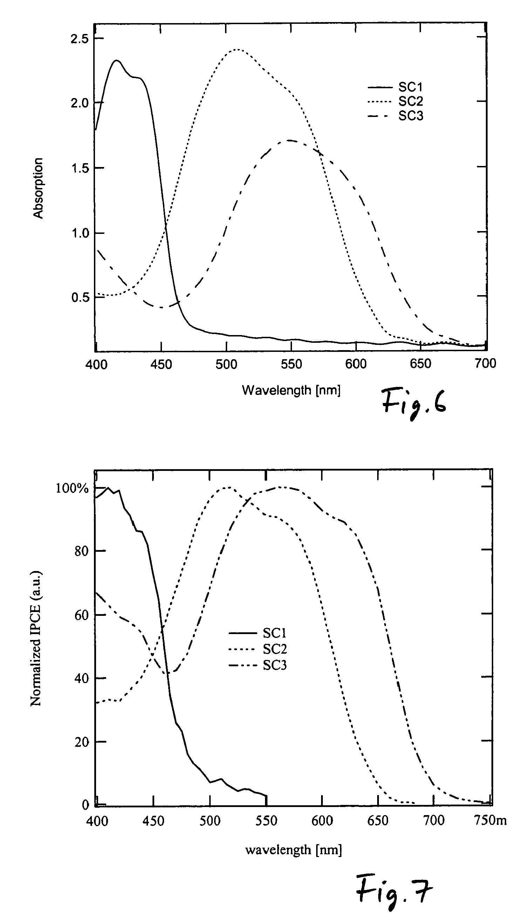

The experiments gave the following results. Fig. 6 shows the absorption spectra of mesoporous titanium dioxide films dyed with merocyanine dyes Sc1, Sc2 and Sc3. The electrodes were deposited onto conducting glass (fluorine-doped tin(IV)oxide), exposed to an alcoholic solution of the three different merocyanine dyes for 24 hours. The three films show distinctively different absorption maxima at 416 nm (Sc1), 509 nm (Sc2) and 548 nm (Sc3). Even with TiO₂ film thicknesses of 3 micrometers the dyed films featured maximum absorption values of about 2. This corresponds to an optical transmission value of 1%.

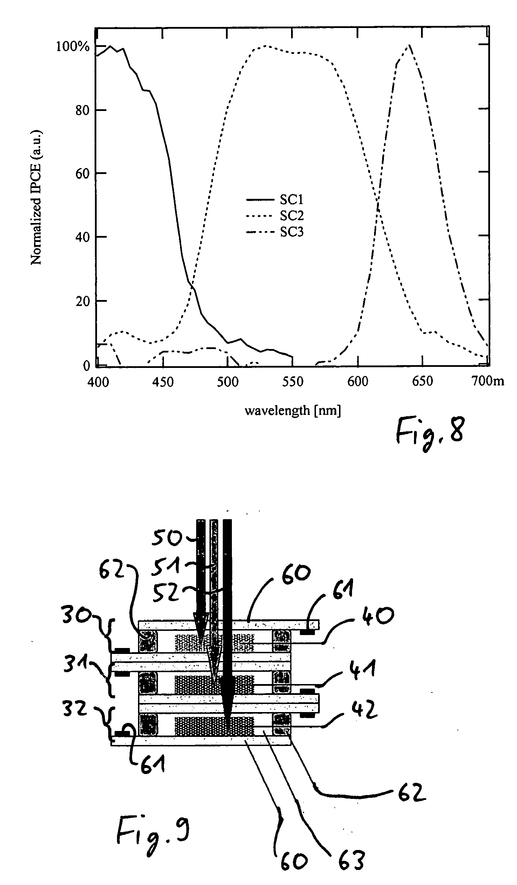

Fig. 7 shows the normalized spectral response (IPCE) of individual photoelectrochemical cells assembled from the dye-sensitized TiO₂ films shown in Fig. 6. The spectral response generally follows the shape of the absorption spectra with the maxima of the spectral response corresponding to the maxima apparent in the absorption spectra. Fig. 8 shows the spectral response of the same cells integrated into a stack as shown in Fig. 9. The three cells have received the reference numerals 30, 31 and 32. They comprise a mesoporous core 40, 41 and 42, respectively, with the dyes Sc1, Sc2 and Sc3, respectively. The penetration depth of different wave length is shown with arrows 50, 51 and 52, respectively. Each cell 30, 31 and 32 has two conducting glass substrates 60 with electrical contacts 61. Said dye comprising cores 40, 41 and 42 are mounted on one glass substrate 60 between the two glass substrates 60 of one cell 40, 41 and 42, respectively. Sealing elements 62 retain an electrolyte 63 within the confined space between the substrates 60. Such a stack is one example of an embodiment with three nearly identical cells, beside the different impregnation of the core 40, 41 and 42 with the dyes Sc1, Sc2 and Sc3, respectively.

The normalized spectral response of the uppermost cell 30 (with Sc1) is not affected by the underlying stack. The normalized spectral response of cell 31 (with Sc2) changes due to the filter layer of the Sc1 cell 30 - especially in the area from 400 to 450 nm, where the normalized spectral response is reduced from above 30 to below 10 % through the overlying Sc1 cell 30. The third cell 32 in the stack is most strongly affected by the integration into the stack. Due to the filter effect of top layers the spectral response of the Sc3 cell 32 within the stack changes significantly. Instead of showing a broad IPCE spectrum with a half-width of about 175 nm, peaking at about 560 nm the wavelength of maximum sensitivity shifts to 640 nm with a half-width of about 50 nm. The normalized spectral response at wavelengths below 600 nm is reduced to <10%, as an effect of the light filtering of the above layers. As a result the stack of cells 30, 31, 32 is sensitive to three distinct wavelength ranges: 400-475 nm; 475-620 nm and 620 to 700 nm.

The dyes used are such as but not limited to cyanine, merocyanine, phtalocyanine, porphyrine, coumarine, squaraine and/or indoline dyes and/or ruthenium polypyridyl complexes. Using non-sensitized TiO₂ it is possible to assemble a UV-sensitive detector because it starts to absorb light at about 400 Nanometer. Ruthenium-dye sensitized photodetectors can detect NIR light up to wavelength of 900 Nanometer. Zinc porphyrine dye shows a strong absorption in the blue and three moderate transitions in the spectral range of 500 to 650 Nanometer. Ruthenium N749, so called black dye, has a broad absorption over the entire visible spectrum with a tail absorption extending into the near infrared. The use of thicker films of such a dye with light scattering particles can be contemplated for the bottom cell in a stack of photosensors. Coumarine C343 has a strong absorption band around 400 to 450 Nanometer and a good photon to electron conversion efficiency.

The invention allows to build nanocrystalline semiconductor electrodes. Preferred materials for the sensor are p-type material, redox electrolyte and organic charge transport material.

Beside the embodiments shown in Figure 1 and 2, it is also possible to provide for so called dense TiO₂ layers between a nanostructured TiO₂ film and a conducting fluorine doped tin oxide film. It has be found that IPCE increased dramatically, when such a dense TiO₂ layer was introduced between the nanostructured TiO₂ film, e.g. layer 40, 41 or 42, and the conducting fluorine doped tin oxide film (FTO), e.g. the glass electrode 60 comprising and covered by such a FTO film. Injection efficiency has more then doubled. A dense tin oxide layer blocks direct contact of the electrolyte or the dye with the underlying FTO (and) substrate and thereby reduces recombination phenomena present in devices without dense TiO₂ layers. Additionally it is possible to work with such cells having a dense tin oxide layer under e.g. 0,4 Volt reverse bias. Then the answer of such cells not only improved in the range form 0 to 40 % white light intensity but also under higher light intensity from 50% onwards.

The photoresponse can be tuned via the thickness of the sensitized TiO₂ layer. Preferably the top stack elements show a filter effect, i.e. the thickness of these layers are greater. With a usual film thickness between 0,5 and 15 micrometer (equally applicable for the dense tin oxide layer, although a thin thickness is usually sufficient), it has been found out that increasing the thickness of the top layer from 2 micrometer to 7 micrometer improves the absorption from 85 to 90 % to more than 99 % thus avoiding potential cross-talk in deeper layers. The actual interesting thickness heavily depends on the dye used.

## Claims

1. A sensor element (1, 20, 21, 22) capable of sensing more than one spectral band of electromagnetic radiation with the same (x-y) spatial location, especially where the dimensions x-y-z form a set of Cartesian coordinates with z parallel to the direction of incident electromagnetic radiation, **characterized in that** the element consists of a stack of sub-elements (3, 5, 7) each capable of sensing different spectral bands of electromagnetic radiation, further **characterized in that** these sub-elements (3, 5, 7) each contain a non-silicon semiconductor where the non-silicon semiconductor in each sub-element (3, 5, 7) is sensitive to and/or has been sensitized to be sensitive to different spectral bands of electromagnetic radiation.

2. The sensor element according to claim 1, wherein the semiconductor is preferably one or more wide-bandgap semiconductors.

3. The sensor element according to claim 1 or 2, wherein the spectral-band sensitization of the semiconductors is made by use of organic and/or inorganic structures of size typically 1-100 nanometers, such as dyes and/or quantum dots and/or similar electron tunneling entities, which permit direct and/or indirect capture of incoming electromagnetic radiation and which may or may not also confer a cascade effect.

4. The sensor element according to claim 1 to 3, used as part of a one-dimensional or two-dimensional array or three-dimensional array of such elements.

5. The sensor element according to one of claims 1 to 4, used for image capture.

6. The sensor element according to one of claims 1 to 5, used for image capture directly and/or using scanning.

7. The sensor element according to one of claims 1 to 6, wherein at least one of the spectral bands of electromagnetic radiation lies in the human-visible range and/or at least one of the spectral bands of electromagnetic radiation lies outside the human-visible range or all the bands of electromagnetic radiation lie in the human-visible range or all the bands of electromagnetic radiation lie outside the human-visible range.

8. The sensor element according to one of claims 1 to 7, wherein the spectral bands lying in the human-visible range are chosen to be such to permit full-colour image capture.

9. The sensor element according to one of claims 1 to 8, wherein the spectral bands of electromagnetic radiation lying outside the human-visible range are chosen to be such to permit multi-wavelength image capture.

10. The sensor element according to one of claims 1 to 9 used as part of a regular and/or irregular array.

11. The sensor element according to one of claims 1 to 10 used as part of a linear or non-linear, or planar or non-planar, or cylindrical-surface, or spherical-surface, or parabolic, or-paraboloid-surface, or other geometrically constructed array.

12. The sensor element according to one of claims 1 to 11 used as part of a regular, two-dimensional, planar array for image capture directly and/or using scanning.

13. The sensor element according to one of claims 1 to 12, used as part of a regular, one-dimensional, linear array for image capture directly and/or using scanning.

14. A single sensor element according to one of claims 1 to 13, used for image capture directly and/or using scanning.

15. The sensor element according to one of claims 1 to 14, wherein the element consists of a stack of sub-elements (3, 5, 7) in which the direction of stacking is parallel to the direction of the incoming electromagnetic radiation and/or obliquely inclined to the direction of the incoming electromagnetic radiation.

16. A sensor element or sub-element according to one of claims 1 to 15, wherein the semiconductor used is titanium dioxide.

17. The sensor element or sub-element according to one of claims 1 to 16, where the dyes used are such as but not limited to cyanine, merocyanine, phtalocyanine, porphyrine, coumarine, squaraine and/or indoline dyes and/or ruthenium polypyridyl complexes, and/or similar entities derived from such dyes, such as but not limited to salts and polymeric derivatives thereof.

18. The sensor element or sub-element according to one of claims 1 to 17, where the electrodes are nanocrystalline semiconductor electrodes.

19. The sensor element or sub-element according to one of claims 1 to 18, where an electrolyte (63) is provided in each sub-element being in contact with electrode-relating elements and the spectral-band sensitized semiconductor material, which is preferably a redox electrolyte or organic charge transport material.

20. The sensor element or sub-element according to one of claims 1 to 19, wherein an additional dense tin oxide layer is provided between the electrode layer (60) and the semiconductor layer (40, 41, 42), especially wherein the electrode layer is a fluorine doped tin oxide film.

21. The sensor element or sub-element according to claim 20, wherein it is operated under reverse bias.

22. A device incorporating at least one sensor element according to one of claims 1 to 21 used for capturing images where part or all of the wavelengths captured fall within the human visible electromagnetic radiation spectrum.

23. A device incorporating at least one sensor element according to one of claims 1 to 21 used for capturing images where part or all of the wavelengths captured fall outside the human visible electromagnetic radiation spectrum.

24. The device according to claim 22 or 23, wherein the order of the wavelengths captured by each sub-element (3, 5 7) with increasing depth from electromagnetic radiation impinging on the device, is or is not necessarily correlated that decreasing wavelength corresponds to increasing depth.

25. The devices according to one of claims 22 to 24 where the choice of and sequencing of appropriate dyes permits very high wavelength sensitivity simultaneously with very high resolution for all the wavelength bands selected across the wavelength range selected.

26. The devices according to one of claims 22 to 24 where the choice of and sequencing of appropriate dyes permits ready reconstruction of true full-colour images or whatever false-colour images may be desired.
